# EUROPEAN PATENT APPLICATION

(11) **EP 2 866 313 A1**
(43) Date of publication of application: **29.04.2015**
(21) Application number: 13306461.8
(22) Date of filing: 23.10.2013
(51) Int. Cl.: H01S 5/024, H01S 5/026

(54) **Integrated circuit**

(71) Applicant: ALCATEL LUCENT, 92100 Boulogne-Billancourt (FR)
(72) Inventor: Shen, Alexandre, 92700 Colombes France (FR); Hernon, Domhnaill, 15 Dublin (IE); Enright, Ryan, 15 Dublin (IE)
(74) Representative: Coghlan, Judith Elizabeth Kensy

(57) **Abstract**

A photonic integrated device and method of providing a photonic integrated device. The device comprises: a temperature sensitive component and a thermoelectric module. The thermoelectric module is formed adjacent the temperature sensitive component and is configured to adjust the temperature of the temperature sensitive component. The first aspect recognises that locating and forming a thermoelectric module adjacent a temperature-sensitive component can be advantageous in dealing with heat generated on an integrated circuit. Furthermore, arranging the thermoelectric module to adjust the temperature of the temperature-sensitive component may negate the need to provide both a thermoelectric module to cool a temperature-sensitive device and a local electric heater adjacent a device. That is to say, the two components may be replaced with a single integrated component in accordance with the first aspect.

## Description

### FIELD OF THE INVENTION

Aspects and embodiments provide a photonic integrated device and a method of providing such an integrated device.

### BACKGROUND

Thermal management of small scale integrated devices is a barrier to enabling a large increase in manageable data traffic. In photonic integrated circuits (PIC) and optoelectronic integrated circuits (IC) there are integrated devices whose large heat flux levels require management. Those large heat flux levels (for example, greater than 1000W/cm²) result in a need to remove heat from an integrated circuit. Some integrated devices or components included in an integrated circuit may be highly temperature sensitive and, as a result, the temperature of those devices may need to be actively managed or controlled. For some devices, that temperature control must be performed within tight limits; for example, within a tolerance of 0.1°C. Temperature control may be necessary on an individual and independent component basis.

In the case of some integrated circuits, integration may be limited by poor efficiency of photonic-based communication. Such efficiency is typically measured in terms of energy consumed per bit of information passed (J/bit). The efficiency of photonic-based communication at short length scales when compared to electronic-based communication may be judged to be poor. If exaflop computing is to become a reality there is a requirement to provide high bandwidth chip-to-chip communication across a small length scale. As a result, device integration densities are likely to be increased to accommodate such bandwidth requirements. In order for such bandwidth requirements to be enabled optically, energy consumption associated with active photonics devices should be significantly reduced in order to overtake electronic arrangements at increasingly smaller length scales. Advanced thermal management concepts have a role to play in reducing energy consumption in photonic and other integrated circuits.

### SUMMARY

It is desired to provide an integrated circuit which addresses some issues with known integrated circuits.

Accordingly, a first aspect provides a photonic integrated device comprising: a temperature sensitive component requiring temperature control and a thermoelectric module formed adjacent the temperature sensitive component and configured to adjust the temperature of the temperature sensitive component.

The first aspect recognises that in terms of thermal management of integrated circuit devices, there are a number of significant issues. Some devices and components formed on an integrated circuit may generate significant heat loads in very small areas and therefore have large heat flux levels. Those heat flux levels may, for example, be greater than 1000W/cm². Such large heat flux may need to be removed in order to ensure reliable operation of a device.

The first aspect recognises that operation of some components may depend upon the temperature of those components and that thermal management of those components may improve component and/ or device operation. For example, some active optoelectronic components, such as lasers, may require that their operational temperature be controlled to within tight operating temperature boundaries. Such boundaries may, for example, be of the order of 0.1 of a degree centigrade. In the case of lasers provided on an integrated circuit, the absolute operating temperature of the laser is a determining factor in its output efficiency. It will therefore be appreciated that lowering the operational temperature of the laser component or device on the integrated circuit may provide a means to provide an order of magnitude improvement in operating efficiency.

The first aspect recognises that an integrated device may comprise an arrangement of components are considered to be inseparably associated and/ or interconnected such that it is considered substantially indivisible. The first aspect may comprise an integrated circuit which includes a temperature-sensitive component and a thermoelectric cooling module formed adjacent set temperature-sensitive component. Provision of a temperature-sensitive component and an adjacent thermoelectric cooling module may allow for efficient temperature management on an integrated circuit.

The first aspect recognises that in the case of photonic integrated circuits (PICs), solutions have been proposed to thermal management which substantially separate functional operation of a photonic integrated circuit from cooling mechanisms required for individual components or elements forming a functioning circuit. In particular, arrangements which operate to cool a number of laser devices found on a chip with a large thermoelectric module (TEM) provided separately to the photonic components may offer inefficient thermal management since in order to ensure that each component is at an appropriate operating temperature, the general cooling of a photonic integrated circuit is offset against individual resistive heaters which are typically provided in the vicinity of each thermally sensitive device and operate to locally adjust device temperature to a required characteristic temperature. In the case of photonic laser devices, for example, that characteristic temperature may be determined by the wavelength of required light output. Provision of both a cooler and a heater may double power requirements in relation to temperature control of each temperature sensitive component and may present a large energy problem when scaled up to control temperature of a device including a plurality of temperature sensitive components.

Such an individual heating approach is highly inefficient and does not provide a scalable solution to an integrated circuit having increased device density. The scalability of such a solution is limited by the inherent inefficiency of a thermoelectric module which may, for example, consume up to a quarter of total power if arranged in accordance with the implementation described above. Furthermore, provision of a large thermoelectric module to cool a plurality of laser devices requires occupation of a large physical volume within an integrated circuit package. Thermally, provision of a large, but remote, thermoelectric module results in a poor thermal design, not least because each laser is cooled to a temperature below that of ambient and then heated with an appropriate local heater. From a thermal point of view, such an arrangement requires the thermoelectric module to carry the load of the laser device and that of the heater.

Aspects recognise that an arrangement in which a large thermoelectric module is provided remote from thermally sensitive devices can lead to issues in relation to the ability of such an arrangement to handle large heat flux levels generated at small length scales. A large local thermal resistance can result in temperature sensitive components operating at a greater temperature than is desired. The efficiency of the component, for example, a laser diode, is therefore potentially an order of magnitude less than may be possible if a more efficient thermal solution could be provided.

The first aspect provides a photonic integrated device. That device may comprise a photonic integrated circuit. The device may comprise a semiconductor device. The device may comprise a module for inclusion in a photonic integrated package. The device may comprise a temperature sensitive component. The temperature sensitive component may comprise a photonic, opto-electronic or electronic component. The component may require temperature control. The component may require tight or close temperature control. The temperature sensitivity of the component may relate to an efficiency of operation, or to functionality. The component may require temperature control to within a degree centigrade. The component may require temperature control to within a fraction of a degree centigrade. The component may require temperature control within a tolerance of 0.1 degree centigrade. The component may require temperature control to within a tolerance of 0.1 degree centigrade or less.

The device may comprise a thermoelectric module. Such a module may act, on application of appropriate voltage, as a heating device, or a cooling device. The thermoelectric module is formed adjacent the temperature sensitive component. The thermoelectric module may thus be integrally formed as part of the device, rather than an add-on component. The thermoelectric module is configured to adjust the temperature of the temperature sensitive component. Adjustment may be performed by heating or cooling. Bringing a thermoelectric module close to the component requiring temperature control can be advantageous, but can be difficult. It will, for example, be appreciated that construction methods of integrated devices may mean that materials having poor thermal properties are used in locations where a material having good thermal properties may be more appropriate. Some aspects and embodiments recognise that use of poorly conductive material in specific locations as the device is fabricated can block heat flow and move heat flow in a different direction. Such directionality of heat flow may allow for closer control and can be advantageous.

The first aspect recognises that locating and forming a thermoelectric module adjacent a temperature-sensitive component can be advantageous in dealing with heat generated on an integrated circuit. Furthermore, arranging the thermoelectric module to adjust the temperature of the temperature-sensitive component may negate the need to provide both a thermoelectric module to cool a temperature-sensitive device and a local electric heater adjacent a device. That is to say, the two components of known arrangements may be replaced with a single integrated component in accordance with the first aspect.

The first aspect further recognises that by reducing the physical distance between a temperature sensitive component and a heating and/or cooling device, efficient thermal management of that component may be provided. In some embodiments, the thermoelectric module may be formed in the region of tens of micrometres from a thermally sensitive device having a similar dimension.

In one embodiment, the temperature dependent component and the thermoelectric module are formed on a shared substrate. Accordingly, forming the thermoelectric module in situ next to the temperature dependent device may ensure appropriately short thermal transfer lengths between those components.

In one embodiment, the temperature dependent component and the thermoelectric module are formed on different substrates which are combined to form the integrated device. Accordingly, it may be possible to form the devices on separate substrates and align the separate substrates to form a unitary integrated photonic device.

In one embodiment, the temperature sensitive component comprises: a semiconductor component. Accordingly, both the temperature sensitive component and the thermoelectric module may be formed by using appropriate semiconductor fabrication processes, including, for example, deposition, etching and similar techniques. If the device comprises a semiconductor device, it may comprise a heterogeneous integrated semiconductor device. In such a device, the materials used to construct the thermoelectric module and the temperature sensitive component, for example, a hybrid laser device or laser diode, are different.

In one embodiment, the semiconductor component comprises: an active component. In one embodiment, the temperature sensitive component comprises: a heat generating component. Accordingly, the thermal adjustment supplied by appropriate forming of a thermoelectric module in situ on a substrate next to a heat generating component may allow for more efficient thermal management. It will be appreciated that short thermal distances may allow for more efficient thermal management of a component and thus by forming a thermoelectric module in situ immediately adjacent to one or more temperature sensitive components, thermal management may be achieved more efficiently.

In one embodiment, the temperature sensitive component comprises: a light generating or light modulating component. Accordingly, in a photonic integrated device, the heat generating component may comprise a device, such as a laser diode, modulator, or similar, which is temperature sensitive and generates heat and light. Active thermal management of that device close to an active lasing region may improve temperature regulation and/or device efficiency.

In one embodiment, the temperature sensitive component comprises: a ring resonator or interferometer. Accordingly, such components may function differently as their temperature changes. Accordingly, being able to adjust their temperature may result in improved component operation. In such devices, their operation may be wavelength dependent, or tuned to a particular wavelength of electromagnetic radiation. Fluctuation in component temperature may result in a detuning in operation of such components and impact operation of a photonic integrated device. Accordingly, where a ring resonator comprises the temperature sensitive component, fine thermal tuning induces a tuning of the resonance wavelength of the rings, which may, for example, be in a laser cavity and as a result a laser may see its wavelength tuned by the ring resonance.

In one embodiment, the device comprises: a control unit arranged to control the thermoelectric module in response to a signal indicative of the temperature of the temperature sensitive component. Accordingly, rather than blindly acting to heat or cool a component, a thermoelectric module can be arranged to cool if a component is too hot, or heat if a component is too cool. A signal may be generated by an appropriately sensor.

In one embodiment, the control unit is operable to control the thermoelectric module to obtain a desired temperature of the temperature dependent component in accordance with feedback from a signal indicative of the temperature of the temperature sensitive component. Accordingly, a thermoelectric module may be used to control or maintain the temperature of a thermally sensitive component at a predefined or desired temperature. Locating the TEM close to the temperature sensitive component may allow for a short response time and dynamic, responsive thermal management. In one embodiment, the thermoelectric cooling module is operable to maintain a substantially constant temperature at the temperature sensitive component.

In one embodiment, one side of the thermoelectric module is thermally coupled to the temperature sensitive component. Integrally forming a TEM as part of a photonic integrated device may allow various physical mechanisms to support thermal management of the combination. To enhance operation of a TEM in relation to thermal control of the temperature sensitive component, steps may be taken to improve thermal coupling beyond that of conduction along a basic shared substrate. In particular, thermal coupling between one side of a TEM and the temperature sensitive device can be enhanced. In one embodiment, the integrated device comprises: a heat transfer enabling element arranged between one side of the thermoelectric module and the temperature sensitive component. The enabling element may comprise a element formed or constructed from a material having a lower heat resistance than surrounding material, thus offering a preferred heat path through a device. That enabling element may be integrally formed as part of said photonic integrated device. The element may form, for example, part of a substrate, or a spacer.

In one embodiment, one side of the thermoelectric module is thermally insulated from the temperature sensitive component. Similarly, arranging for one side of the TEM to be thermally insulated from the temperature sensitive device can enhance thermal management techniques and ensure that heat is effectively inserted or extracted from the temperature sensitive component by the TEM. In one embodiment, the integrated device comprises: a heat transfer impeding element arranged between the side of the thermoelectric module and the temperature sensitive component. In one embodiment, the heat transfer impeding or heat transfer enabling element is formed as part of the integrated device. The enabling element may comprise a element formed or constructed from a material having a higher heat resistance than surrounding material, thus offering a thermal block in a device. That impeding element may be integrally formed as part of said photonic integrated device. The element may form, for example, part of a substrate, or a spacer, or any appropriately placed or formed physical feature of said photonic integrated device.

In one embodiment, a hot side of the thermoelectric module is thermally coupled to a heat sink. Accordingly, heat may be transferred away from said TEM.

In one embodiment, the heat sink comprises: a heat transfer element having a higher heat conductivity than surrounding device material, coupled to a heat radiator. Accordingly, a via having a lower thermal resistivity than surrounding material may be provided to offer a preferential thermal path to heat through said device to said heat radiator. In one embodiment, the heat transfer element is formed as part of the integrated circuit.

In one embodiment, the heat sink comprises: at least one microfluidic channel arranged to contain heat transfer fluid to transport heat away from the hot side of the thermoelectric cooling module. In one embodiment, the microfluidic channel is formed as part of the integrated device. Accordingly, microfluidic channels and associated fluid may be provided to transport heat away from a hot side of the TEM. Arranging or forming cooling channels adjacent a hot side of the thermoelectric module can improve thermal performance of the thermoelectric module. It can be difficult to process the laser, TEM and microfluidic channels in one fabrication step. Several fabrication steps may be required.

In one embodiment, the integrated device comprises a plurality of temperature sensitive components and thermoelectric modules. Accordingly, it will be appreciated that a single TEM may provide cooling to a plurality of directly adjacent temperature sensitive component. Similarly, a plurality of TEMs may provide cooling to a single thermally sensitive component. In other words, in some arrangements, a temperature sensitive element may have a plurality of TEMs formed immediately adjacent, configured to adjust the temperature of that component.

A second aspect provides a method of providing a photonic integrated device, said method comprising: providing a temperature sensitive component requiring temperature control and forming a thermoelectric module adjacent the temperature sensitive component configured to adjust the temperature at the temperature sensitive component.

In one embodiment, the method comprises forming the temperature dependent component and the thermoelectric module on a shared substrate.

In one embodiment, the method comprises: forming the temperature dependent component and the thermoelectric module on different substrates which are combined to form the integrated device.

In one embodiment, the temperature sensitive component comprises: a semiconductor component.

In one embodiment, the semiconductor component comprises: an active component.

In one embodiment, the temperature sensitive component comprises: a heat generating component.

In one embodiment, the temperature sensitive component comprises: a light generating or light modulating component.

In one embodiment, the temperature sensitive component comprises: a ring resonator or interferometer.

In one embodiment, the method comprises: arranging a control unit to control the thermoelectric module in response to a signal indicative of the temperature of the temperature sensitive component.

In one embodiment, the method comprises configuring the control unit to be operable to control the thermoelectric module to obtain a desired temperature of the temperature dependent component in accordance with feedback from a signal indicative of the temperature of the temperature sensitive component.

In one embodiment, the thermoelectric cooling module is operable to maintain a substantially constant temperature at the temperature sensitive component.

In one embodiment, the method comprises: thermally coupling one side of the thermoelectric module to the temperature sensitive component.

In one embodiment, the method comprises: providing a heat transfer enabling element arranged between one side of the thermoelectric module and the temperature sensitive component.

In one embodiment, the method comprises: arranging one side of the thermoelectric module such that it is thermally insulated from the temperature sensitive component.

In one embodiment, the method comprises: arranging a heat transfer impeding element between one side of the thermoelectric module and the temperature sensitive component.

In one embodiment, the method comprises: forming the heat transfer impeding or heat transfer enabling element as part of the integrated device.

In one embodiment, the method comprises: thermally coupling a hot side of the thermoelectric module to a heat sink.

In one embodiment, the heat sink comprises: at least one microfluidic channel arranged to contain heat transfer fluid to transport heat away from the hot side of the thermoelectric cooling module.

In one embodiment, the method comprises: forming the microfluidic channel as part of the integrated device.

In one embodiment, the heat sink comprises: a heat transfer element having a higher heat conductivity than surrounding device material, coupled to a heat radiator.

In one embodiment, the method comprises: forming the heat transfer element as part of the integrated circuit.

In one embodiment, the method comprises: providing a plurality of temperature sensitive components and thermoelectric modules.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figure 1 illustrates a state-of-the-art photonic integrated circuit architecture;
Figure 2 shows an example known of photonic integrated chip packaging comprising a large, separate thermoelectric cooling module;
Figure 3 illustrates schematically a photonic integrated device according to one embodiment;
Figure 4 illustrates schematically the arrangement of Figure 3 as viewed from point A on Figure 3;
Figure 5 shows schematically simulation results of total consumed power of one possible modelled embodiment;
Figure 6 illustrates schematically a photonic integrated device according to one embodiment;
Figure 7 illustrates schematically a device according to a further embodiment;
Figure 8 illustrates schematically two further possible embodiments; and
Figure 9 illustrates schematically an alternative embodiment.

### DESCRIPTION OF THE EMBODIMENTS

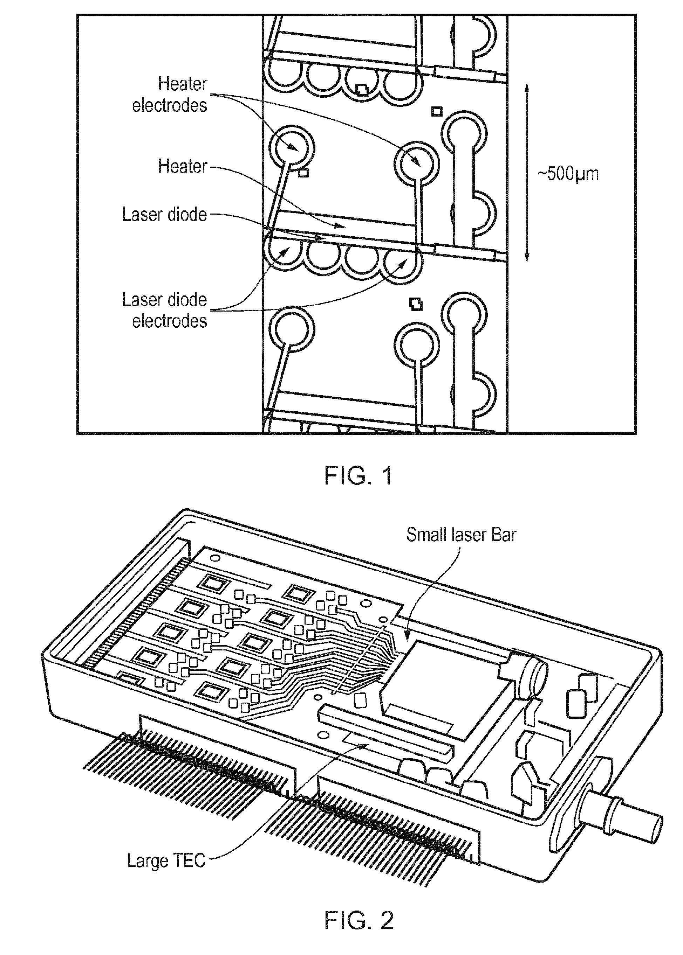

Figure 1 shows a state-of-the-art Photonic Integrated Circuit architecture in which a heater is provided adjacent a laser diode. It can be seen that the functional parts of the heater and laser diode are substantially adjacent.

Figure 2 shows an example photonic integrated chip package in which a large thermoelectric cooler is operable to cool a small laser bar. The small laser bar is labelled, as is the large thermoelectric cooler (TEC). It can be seen that the thermoelectric cooler takes up a large region within the photonic integrated circuit package. Furthermore, it is clear that a macroscopic gap exists between the laser bar and the cooler. That is to say, there is a significant distance between where heat is generated at the laser and where the thermoelectric cooling module is able to provide its cooling. Furthermore, it can also be seen that the thermoelectric cooling device shown in Figure 2 is a separate "add-on" component which is integrated into the package after the primary functionality of the photonic integrated circuit has been designed on a substrate.

### Overview

Before discussing the embodiments in any more detail, first an overview will be provided. Aspects and embodiments recognise that optimization of thermal management of an integrated photonic device may occur as a result of a more holistic design approach. That is to say, optimizing a thermal solution at each layer in an integrated device design can result in the placing of cooling or heat management elements close to a heat source. Such a heat source may comprise a laser, transistor or similar component. That placing of heat management holistically within an integrated circuit may be applied throughout layers of an integrated circuit all the way out to design of a whole package.

Aspects and embodiments recognise that one important aspect in relation to cooling, for example, in relation to photonic devices, is that of temperature control. Aspects and embodiments can provide a means to replace individual heaters and shared cooling devices with individual micro thermoelectric devices which can operate as both coolers and heaters and thus provide small scale temperature control, be it heating or cooling, in relation to each individual temperature-sensitive component. That temperature sensitive component may, for example, comprise a laser diode. It will be appreciated that some technology adaptation may be needed in order to integrate a thermoelectric module into a typical photonic integrated device and, in particular, the thermoelectric module fabrication process into the fabrication process of a typical integrated circuit.

In some embodiments, a thermoelectric module can be placed or formed on an integrated circuit in the immediate vicinity of a laser device. Depending on the laser device architecture, thermoelectric module integration may be achieved by directly replacing a resistive heater, such as that shown in Figure 1, in terms of spatial location, with a directly integrated thermoelectric module. Alternatively, the thermoelectric module may be constructed close to a laser device by depositing thermoelectric material directly on top of a solid state spreading geometry and active region of a laser device embedded inside a thermoelectric material. Depending on laser architecture, either approach may be appropriate. That laser architecture may comprise a flip-chip laser or, for example, a hybrid III-V-on-silicon laser.

In addition to provision of a micro thermoelectric module, it will be appreciated that some embodiments may address thermal management of an integrated circuit by further addressing means to transport heat generated by, for example, a laser and/or a micro thermoelectric module. The heat generated by those devices may be removed at the lowest possible temperature to try to ensure most efficient and reliable operation of the devices and the photonic integrated circuit. Accordingly, various means to disperse heat from a temperature-sensitive device are described herein.

According to some embodiments, microfluidic cooling can be used. Such microfluidic cooling may involve circuits which utilise fluids having a low thermal resistance to transport heat. Microfluidic cooling may be provided as close to heat sources as possible. In some embodiments, the microfluidic circuits may be integrated as close to the heat source as possible. In some embodiments, microfluidic circuits can be constructed as part of an integrated circuit fabrication process. According to some embodiments, a single phase microfluidic arrangement can be used. Alternative embodiments may allow for integration into integrated circuit packaging a microfluidic circuit to cool down individual hotspots on an integrated circuit in operation.

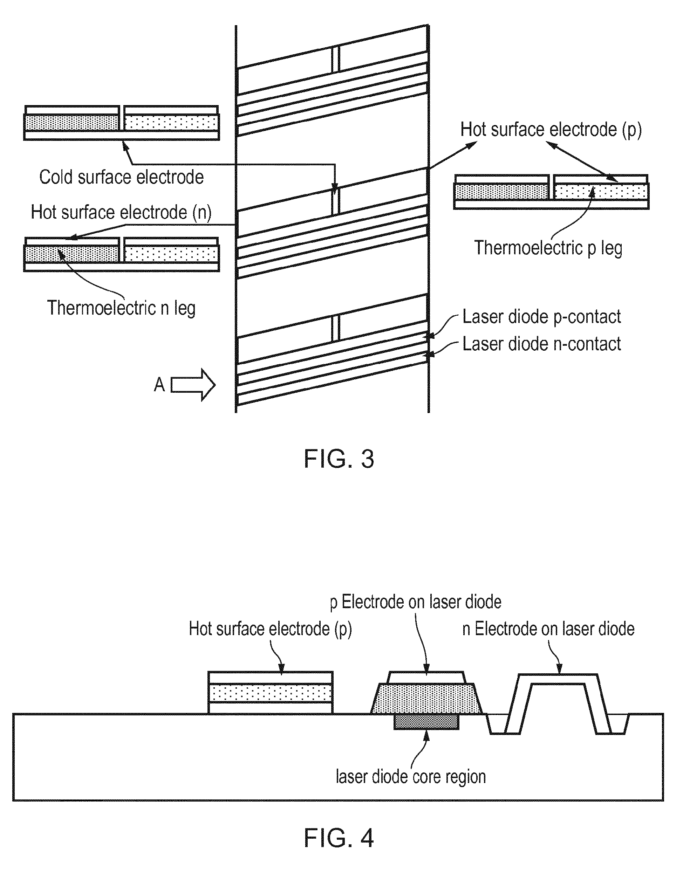

Figures 3 and 4 show one possible embodiment of an arrangement in which a thermoelectric module can be used to adjust the temperature of a component sensitive to temperature included on an integrated circuit. According to such an arrangement, one pair of thermoelectric legs is arranged with appropriate electrode dispositions.

Figure 3 illustrates schematically a possible embodiment of a photonic integrated device in accordance with one implementation. As can be seen schematically in Figure 3, there are three laser diode components, each arranged immediately adjacent an appropriately dimensioned thermoelectric module. Each thermoelectric module comprises a pair of legs. Each thermoelectric module may comprise a thermoelectric n leg and a thermoelectric p leg and, in dependence upon the direction of a voltage applied across those legs via appropriately placed electrodes, the thermoelectric pair of legs may act to cool or to heat the laser diode. In the particular arrangement shown in Figure 3, a cold surface electric of the thermoelectric module is arranged to be in close thermal contact with a local component, in this case a laser diode, whose operation is temperature sensitive and in this case whose temperature is to be controlled. It will be understood that heat may be transferred from the hot surface of the thermoelectric module in accordance with one of various techniques described below.

Figure 4 illustrates schematically the embodiment represented in Figure 3 viewed from point A in Figure 3. Each thermoelectric module and laser diode are formed on an indium phosphate substrate. In the arrangement illustrated, the cold surface dielectric of the thermoelectric module is arranged such that it is in the immediate vicinity of the laser diode core region which generates heat. Such an arrangement can allow the thermoelectric module to transport heat away from the laser diode core region.

A numerical simulation using one dimensional modelling of arrangements having different thermal parameters indicates that by using integrated micro coolers in an arrangement such as that shown in Figures 3 and 4, rather than an arrangement such as that shown in Figures 1 and 2, a saving of more than 76% of the total power consumed in the previous arrangement is foreseen. In particular, the arrangement of Figures 3 and 4 is expected to use in the order of 4W compared to approximately 17W in an arrangement such as that shown in Figures 1 and 2.

**Table 1: Transport properties used in thermoelectric calculations**

| | |
|---|---|
| ZT(85°C)= | 1,928 |
| S (V/K) = | 0,003 |
| K (W/K) = | 0,00894 |
| R (Ohm) = | 0,187 |

Table 1 illustrates the thermoelectric material parameters used for the numerical simulation calculations referred to above. For the purposes of the calculation, an arrangement involving 10 laser diodes were taken into account, each generating 100mW of heat power. The thermoelectric material parameter ZT∼2 corresponds to a performance of nanoparticle based thermoelectric materials. In the arrangement shown in Figures 1 and 2, the heater element is assumed to provide an additional 100mW of heat power and commercially available thermoelectric module cooler parameters were used. The laser junction temperature was proposed to be set at 20°C and the ambient temperature varied from 30°C to more than 90°C. In a classic configuration such as that shown in Figures 1 and 2, the arrangement typically ceases to function when ambient temperature reaches above 70°C, since the high ambient temperature causes inefficient functioning of the large thermoelectric cooler module in that arrangement.

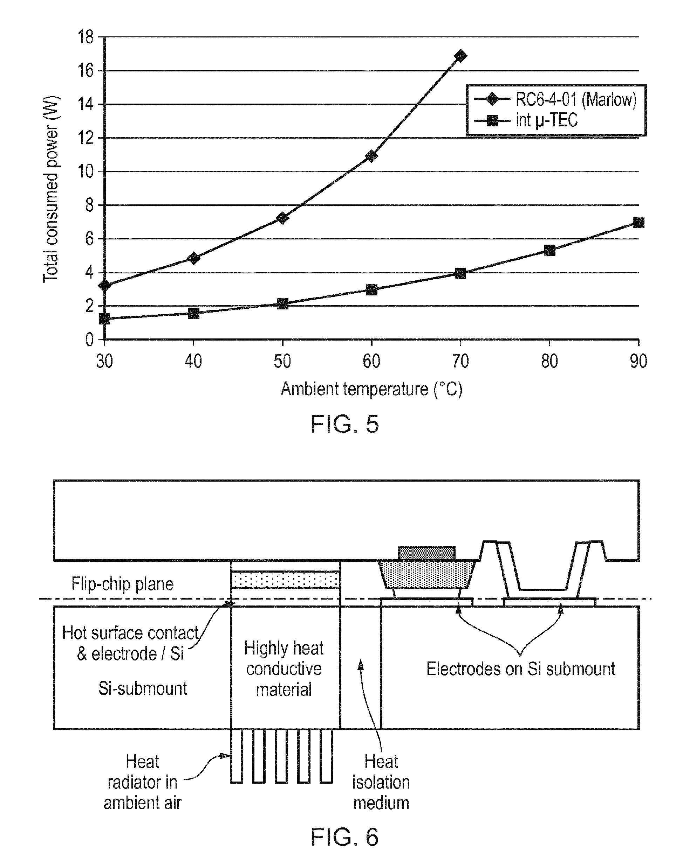

Figure 5 illustrates schematically the numerical simulation results obtained in accordance with calculations as described above. The total consumed power of a 10 laser bar as a function of the ambient temperature is illustrated. The upper curve illustrates the results calculated for a commercially available thermoelectric cooler on a macro scale such as that shown in Figures 1 and 2. The lower curve illustrates schematically the results calculated for an arrangement such as that shown in Figures 3 and 4 using an integrated thermoelectric module flip-chip configuration.

The remaining Figures illustrate various embodiments of aspects described herein. Throughout the remaining Figures, only one laser diode and associated thermoelectric module is shown, but it will be appreciated that the general arrangement may be expanded to encompass any integrated circuit having further thermally sensitive components and thermoelectric modules.

In some embodiments, the arrangement is a flip-chip laser diode arrangement on a silicon submount. Figure 6 illustrates schematically a passive heat duct which uses a radiator to evacuate heat from the hot surface of the micro thermoelectric module. In particular, it can be seen in Figure 6 that the laser diode is arranged to be close to the cooled surface of the thermoelectric module. The heat from the hot surface of the micro thermoelectric module is evacuated by appropriate placing of an efficient heat conductive material; for example, metals such as gold, copper or similar. That highly heat-conductive material acts as a through-silicon via (TSV). Similar TSV options may include copper or carbon nanotubes. The highly heat-conductive material is arranged such that it links to a radiator which emerges in ambient air. In the arrangement shown in Figure 6, the highly efficient heat-conductive element is thermally and electrically isolated from the laser p and n electrodes by an appropriately placed element. The isolation medium can, for example, be air or another appropriate material (for example, a thin silicon oxide layer) which acts as a thermal and heat isolating barrier between the hot side of the thermoelectric module and the heat generating element of, in this instance, the laser diode.

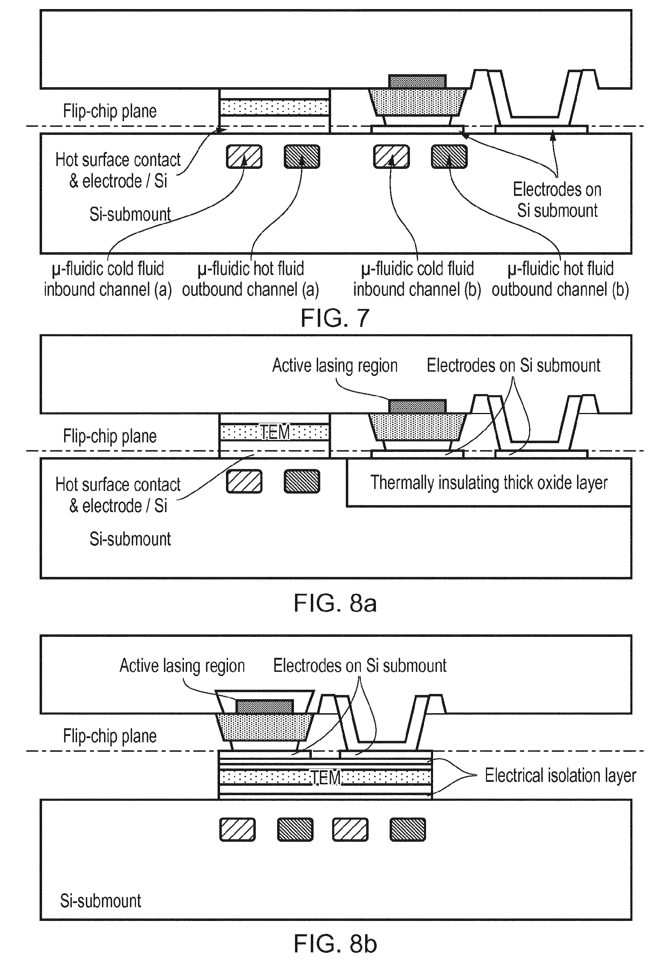

Figure 7 illustrates schematically various heat management options in accordance with various embodiments. According to the arrangements shown in Figure 7, it is possible to arrange a global fluidic circuit which runs under all the hot services of micro thermoelectric modules provided in a device. Such an arrangement may help to evacuate heat s in relation to a plurality of heat-generating elements of a device. Each micro thermoelectric module may comprise one or more thermoelectric elements which can be wired either in series or parallel, depending on the required resistance characteristics of a given micro thermoelectric module array.

According to the arrangement shown in Figure 7, a photonic integrated circuit chip set is flip-chipped on a silicon-based submount and microfluidic channels are designed and fabricated into the silicon-based submount. Refrigerant fluid can circulate just beneath the hot surfaces. According to some options, microfluidics can be provided below the hot electrodes of the micro thermoelectric coolers such that the hot surface temperatures can be lowered. In such an embodiment, it is possible to provide one microfluidic pump to be used for the entire photonic integrated circuit. It will, of course, be appreciated that it is possible to provide a microfluidic pump in relation to each hot spot. In all cases, a microfluidic circuit and micro pump arrangement is carefully designed and dimensioned to evacuate efficiently the amount of heat it is determined needs to be evacuated from a particular photonic integrated device configuration. It will be appreciated that a flip-chip arrangement may be implemented even if all electrode surfaces are not in the same plane.

Figure 8 illustrates schematically further possible device configurations in accordance with some embodiments.

Figure 8a illustrates an arrangement in which p and n contacts for the laser are thermally isolated from a silicon substrate by a thick, low-thermal conductivity layer such as silicon oxide. Such an arrangement allows the InP chip to be cooled effectively by a micro thermoelectric module, whilst minimising heat leakage from a potentially warmer silicon submount which is in thermal contact with the hot side of the thermoelectric module. In the arrangement shown, microfluidic channels remove the heat from the hot side of the micro thermoelectric module at Tₕₒₜ.

Figure 8b illustrates an arrangement in which the micro thermoelectric module spans the width of the p and n electrodes of the laser diode. The electrodes of the laser diode are bonded to the top of the micro thermoelectric module. Electrical isolation layers can be deposited or grown in between the electrodes of the laser diode and between those electrodes and the silicon submount. Again, in the embodiment shown, microfluidic channels are arranged to remove the heat from the hot side of the micro thermoelectric module at Tₕₒₜ.

It will be understood that in the arrangement of Figure 8b the thermoelectric module is not monolithically integrated on the laser chip but is instead formed on the silicon submount. Integration is then considered to be hybrid and the thermoelectric module material(s) can be independently optimized from the photonic circuit technology constraints.

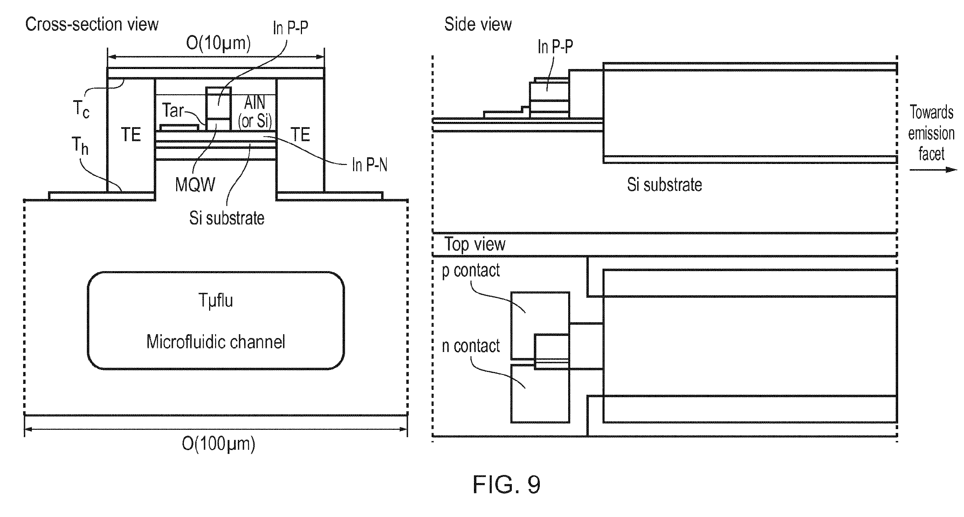

Figure 9 illustrates schematically an embodiment in which a heat-generating element is embedded inside a thermoelectric module structure. The hotspot, in this particular arrangement, a laser core, is thermally isolated from the thermoelectric module structure by appropriately chosen isolation media. As shown, the upper cold surface of the thermoelectric module is operable to cool the laser core down, whilst the heat from the bottom hot surface of the thermoelectric module is evacuated, in the arrangement shown, by a microfluidic channel system or by a radiator system similar to that illustrated schematically in Figure 6.

In the arrangement of Figure 9, an integrated micro thermoelectric cooler for a hybrid III-V-on-silicon semiconductor laser is shown. It will be appreciated that following a typical III-V material bond and etch step, a laser device can be encapsulated in an electrically insulating, but thermally conductive, material. A thin electrical isolation layer (for example, silicon oxide) is deposited, followed by a thermoelectric material and appropriate electrodes. Such an arrangement may take advantage of the large thermal resistance associated with the laser bonding layer, for example BCB and the silicon oxide isolation layer of the silicon-on-oxide wafer. According to such an arrangement, heat flows from the active region of the laser diode to the cold junction of the thermoelectric device and is then electrically pumped to the hot junction of the thermoelectric device. By bringing a microfluidic circuit sufficiently close to the hot junction of the thermoelectric cooler, the thermal path of least resistance can allow heat to drain into the microfluidic channel rather than diffusing back to the active region via the silicon oxide layer and bonding layer. In practice, optical confinement of the laser core and mechanical protection of the deep ridge structure of the laser guide are provided by burying the laser structure under BCB (not shown in the Figure) which is between the InP:p, MQW laser structure and the silicon thermal isolation material.

All aspects and embodiments recognise that data traffic rates are growing exponentially and high bandwidth technology is required to deliver the required level of growth. Photonic integrated circuits in general and short reach optical communication approaches can provide energy efficient solutions to enable large scale data traffic growth, but thermal management of such integrated devices is a critical bottleneck in allowing scalable data traffic growth.

Aspects and embodiments recognise that a holistic approach to thermal problems posed by photonic integrated circuits may be beneficial and can allow energy efficient, scalable, reliable and low-cost cooling designs for integrated photonic devices. Aspects and embodiments may provide an efficient, scalable, integrated thermal solution. Improved temperature control and lower device temperature may also be used to obtain greater device performance and longer device lifetime. Aspects recognise that dealing with a thermal problem as close to where the heat is generated as possible may optimize treatment of a thermal problem.

A person of skill in the art would readily recognize that steps of various above-described methods can be performed by programmed computers. Herein, some embodiments are also intended to cover program storage devices, eg, digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

Aspects and embodiments recognise that although temperature control can already be provided, temperature control while removing extremely high heat fluxes is challenging and cannot be met by known technologies. In order to remove high heat fluxes a different architecture, in accordance with aspects and embodiments, can be provided.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/ or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A photonic integrated device comprising:
a temperature sensitive component requiring temperature control and
a thermoelectric module formed adjacent said temperature sensitive component and arranged to adjust the temperature of said temperature sensitive component.

2. A device according to claim 1, wherein said temperature dependent component and said thermoelectric module are formed on a shared substrate.

3. A device according to claim 1, wherein said temperature dependent component and said thermoelectric module are formed on different substrates which are combined to form said integrated device.

4. A device according to any preceding claim, in which said temperature sensitive component comprises: a heat generating component.

5. A device according to any preceding claim, wherein said device comprises: a control unit arranged to control said thermoelectric module in response to a signal indicative of the temperature of said temperature sensitive component.

6. A device according to any preceding claim, wherein said control unit is operable to control said thermoelectric module to obtain a desired temperature of said temperature dependent component in accordance with feedback from a signal indicative of the temperature of said temperature sensitive component.

7. A device according to any preceding claim, wherein one side of said thermoelectric module is thermally coupled to said temperature sensitive component.

8. A device according to any preceding claim, wherein said integrated device comprises: a heat transfer enabling element arranged between one side of said thermoelectric module and said temperature sensitive component.

9. A device according to any preceding claim, wherein one side of said thermoelectric module is thermally insulated from said temperature sensitive component.

10. A device according to any preceding claim, wherein said integrated device comprises: a heat transfer impeding element arranged between one side of said thermoelectric module and said temperature sensitive component.

11. A device according to claim 10, wherein said heat transfer impeding or heat transfer enabling element is formed as part of said integrated device.

12. A device according to any preceding claim, wherein a hot side of said thermoelectric module is thermally coupled to a heat sink.

13. A device according to claim 12, wherein said heat sink comprises: at least one microfluidic channel arranged to contain heat transfer fluid to transport heat away from said hot side of said thermoelectric cooling module.

14. A device according to any preceding claim, wherein said integrated device comprises a plurality of temperature sensitive components and thermoelectric modules.

15. A method of providing a photonic integrated device, said method comprising:
providing a temperature sensitive component requiring temperature control and forming a thermoelectric module adjacent said temperature sensitive component configured to adjust the temperature at said temperature sensitive component.
